# EUROPÄISCHE PATENTANMELDUNG

(11) **EP 2 022 643 A2**
(43) Veröffentlichungstag der Anmeldung: **11.02.2009**
(21) Anmeldenummer: 08104663.3
(22) Anmeldetag: 08.07.2008
(51) Int. Cl.: B41N 3/08

(54) **Entwicklung von Druckplatten in Offsetdruckmaschinen**

(30) Priorität: 24.07.2007 DE 102007034880
(71) Anmelder: Heidelberger Druckmaschinen AG, 69115 Heidelberg (DE)
(72) Erfinder: Bechberger, Thomas, 76684 Östringen (DE); Dr. Dietze, Martin, 63225 Langen (DE); Dr. Hauck, Axel, 76227 Karlsruhe (DE); Pfeiffer, Nikolaus, 69118 Heidelberg (DE)

(57) **Zusammenfassung**

Die Erfindung betrifft eine Vorrichtung und ein Verfahren zur Entwicklung von Druckplatten (10) in einer Druckmaschine (1) mit wenigstens einem Druckwerk (2). Das Verfahren zeichnet sich dadurch aus, dass eine bebilderte, nicht entwickelte Druckplatte (10) in wenigstens einem Druckwerk (2) der Druckmaschine (1) vor dem Druckbeginn zum Anfeuchten mit Feuchtmittel für eine Einwirkungsdauer beaufschlagt wird, welche wenigstens der eineinhalbfachen Zeitspanne oder Anzahl von Maschinenumdrehungen entspricht, welche beim Einsatz einer bereits entwickelten Druckplatte (10) in der selben Druckmaschine (1) vor dem Druckbeginn vorgesehen sind.

## Beschreibung

Die vorliegende Erfindung betrifft eine Vorrichtung und ein Verfahren zur Entwicklung von Druckplatten in einer Druckmaschine mit wenigstens einem Druckwerk.

In Offsetdruckmaschinen befinden sich in den einzelnen Druckwerken jeweils Druckplatten, welche für einen Farbauszug ein Druckbild tragen Um das Druckbild auf den Druckplatten aufzubringen, werden die Druckplatten entsprechend der Farbauszüge beschrieben. Dieses Beschreiben der Druckplatte geschieht während des Belichtungsprozesses, welcher zum Beispiel mittels eines Lasers vorgenommen werden kann. Durch das Belichten der Druckplatte werden entweder die später druckenden oder die später nicht druckenden Bereiche verändert. Die jeweils nicht belichteten und nicht beschriebenen Bereiche müssen dann in einem Entwicklungsschritt behandelt werden, so dass sich letztendlich die unterschiedliche Oberflächenbeschaffenheit von nicht beschriebenen und beschriebenen Bereichen einstellt. Dabei ist die Oberfläche der nicht beschriebenen Bereiche nach dem Entwicklungsverfahren meist so beschaffen, dass diese Bereiche farbabweisend sind, während die beschriebenen Bereiche der Druckplatten farbaufnehmend sind. Durch das Zuführen von Farbe im Druckwerk werden dann die Druckplatten jeweils mit der entsprechenden Farbe beaufschlagt und übertragen so eingefärbt das Druckbild auf einen Gummituchzylinder, welcher wiederum mit einem Gegendruckzylinder im Druckspalt zusammenwirkt. In diesem Druckspalt wird dann die Farbe auf zu bedruckende Bogen oder Bahnen übertragen. Das Belichten der Druckplatten erfolgt meist außerhalb der Druckmaschine in Druckplattenbelichtern. Es gibt aber auch Druckmaschinen, welche nach dem Prinzip der Direktbebilderung (DI Technologie) arbeiten, bei dem sich die Belichtungseinrichtung im Druckwerk in unmittelbarer Nähe des Plattenzylinders mit der Druckplatte befindet. In diesem Fall wird die Druckvorlage digital in Farbauszügen an den Druckplattenbelichter im Druckwerk übertragen und dort vor Ort meist mittels eines Lasers auf die Druckplatten der Druckplattenzylinder geschrieben. Da bei diesen Maschinen die Druckplatten erst in der Maschine beschrieben werden, muss folglich auch die Entwicklung der Druckplatte in der Maschine erfolgen. Bei außerhalb der Druckmaschine belichteten Druckplatten kann die Entwicklung der Druckplatten wiederum außerhalb der Druckmaschine, aber auch in der Druckmaschine erfolgen. Wenn die Druckplatten in der Druckmaschine entwickelt werden, so geschieht dies durch den Auftrag von Farbe und Feuchtmittel. Solche in der Maschine zu entwickelnden Druckplatten werden auch als prozesslose Druckplatten bezeichnet.

Eine solche Druckmaschine zur Bebilderung in der Maschine ist aus der Patentanmeldung US 2007/0095232 A1 bekannt. Hierbei weist jedes Druckwerk eine Laserbebilderungseinheit auf, welche im Bereich des Plattenzylinders angeordnet ist. Die auf dem Plattenzylinder aufgespannten Druckplatten können mit dieser Laserbebilderungseinrichtung beschrieben werden. Die mit dem Laser beschriebenen Bereiche der Druckplatte härten aus, während die nicht beschriebenen Bereiche durch einen Entwicklungsprozess in der Maschine mittels Farbe und Feuchtmittel farbabweisend blank gemacht werden. Um die Bebilderung mittels Laser zu verbessern, sind die Druckwerke gegen einfallendes Licht abgedeckt. Auf diese Art und Weise wird sichergestellt, dass kein oder nur wenig Licht mit einer Wellenlänge kürzer als 450 Nanometer die Druckplatten erreicht. Damit werden ungewollte Reaktionen der Druckplattenoberfläche mit einfallendem Tageslicht vermieden.

Beim Entwickeln von Druckplatten in der Druckmaschine mittels Aufbringen von Feuchtmitteln und Farbe ergeben sich jedoch in der Realität häufig Probleme, da entweder nicht ausreichend Feuchtmittel oder zuviel Farbe aufgetragen wird. Meist geschieht der Auftrag von Feuchtmittel und Farbe einfach durch die Inbetriebnahme der Druckmaschine für den Druckbetrieb. Dadurch wird jedoch die Oberfläche der Druckplatte in der Druckmaschine oft nicht optimal entwickelt, so dass das Druckbild später nicht den qualitativen Anforderungen entspricht. Aus diesem Grund stehen viele Druckereien der Technik des Entwickelns in der Druckmaschine (DoP Development on Press) sehr skeptisch gegenüber. Eine Lösung für dieses Problem ist der Patentanmeldung US 2007/0095232 A1 nicht zu entnehmen.

Es ist daher Aufgabe der vorliegenden Erfindung, eine Vorrichtung und ein Verfahren zur Entwicklung von Druckplatten in einer Druckmaschine zu schaffen, welches eine zuverlässige und für den Drucker reproduzierbare Entwicklung der Oberfläche der Druckplatte in der Druckmaschine ermöglicht.

Erfindungsgemäß wird die Aufgabe durch Patentanspruch 1 gelöst. Vorteilhafte Ausgestaltungen der Erfindung sind den Unteransprüchen und den Zeichnungen zu entnehmen. Die erfindungsgemäße Vorrichtung und das erfindungsgemäße Verfahren sind für den Einsatz in allen Offsetdruckmaschinen geeignet, welche den Einsatz von in der Druckmaschine zu entwickelnden Druckplatten ermöglichen. Dies erstreckt sich sowohl auf Bogenoffsetdruckmaschinen als auch auf Rollenoffsetdruckmaschinen. Während beim herkömmlichen DoP-Verfahren zur Entwicklung der belichteten Druckplatten in der Maschine die normale Druckinbetriebnahmeprozedur vorgenommen wird, welche zu dem bekannten Problem führt, sind gemäß der vorliegenden Erfindung die Prozesse vor dem Vordruckbetrieb speziell auf die Entwicklung der belichteten Druckplatten in der Druckmaschine abgestimmt und vordefiniert. Wird in die Druckmaschine eine neu bebilderte prozesslose Druckplatte eingelegt oder bei einer Druckmaschine mit DI-Technik in der Maschine bebildert, so wird die Druckplatte vor dem Druckbeginn zunächst während einer Einwirkungsdauer mit Feuchtmittel versehen, welche wenigstens die eineinhalbfache Zeitspanne oder Anzahl von Maschinenumdrehungen beträgt als die Zeitspanne zum Anfeuchten beim Einsatz einer bereits entwickelten Druckplatte in der selben Druckmaschine beträgt. Es wird damit erstmals ein Unterschied bei der Inbetriebnahme einer Druckmaschine in Bezug auf das Anfeuchten zwischen dem Einsatz einer neu bebilderten und noch nicht entwickelten Druckplatte und einer bereits entwickelten Druckplatte gemacht. Durch die wenigstens eineinhalbfach so lange Zeitspanne oder eine entsprechende Anzahl von Maschinenumdrehungen kann das Feuchtmittel länger auf die Druckplatte einwirken als dies bei der herkömmlichen Inbetriebnahme der Druckmaschine möglich ist. Dadurch kann die beim Entwicklungsprozess in den druckenden oder nicht druckenden Bereichen abzutragende obere Plattenschicht besser aufquellen, so dass ein zuverlässiges Abtragen dieser Schicht sichergestellt wird. Grundsätzlich wird bei der DoP-Technologie die Oberfläche der Plattenschicht mittels Feuchtmittel zum Quellen gebracht, während das Abtragen der aufgequollenen Plattenschicht mittels aufgetragener Druckfarbe und Abziehen der aufgequollenen Plattenschicht durch benachbarte Walzen oder Zylinder erfolgt. Durch das gründliche und deutlich längere Einwirken des Feuchtmittels auf die Druckplatte wird aber das Abtragen der obersten Plattenschicht enorm verbessert, so dass die Druckqualität zu Beginn des Fortdrucks im Vergleich zu konventionell außerhalb der Druckmaschine entwickelten Druckplatten nicht wesentlich schlechter ist. Dabei kann vorgesehen sein, dass die Einwirkdauer des Feuchtmittels zum Anfeuchten der Druckplatte aufgeteilt wird auf eine oder mehrere separate Anfeuchtphasen und das Anfeuchten vor Fortdruckbeginn. Wichtig ist nur, dass das Anfeuchten bei einer nicht entwickelten Druckplatte insgesamt deutlich länger dauert als bei einer bereits entwickelten Druckplatte.

In einer ersten Ausgestaltung der Erfindung ist vorgesehen, dass für eine Emulsion aus Farb- und Feuchtmittel dem Feuchtmittel beim Entwickeln der Druckplatte in der Druckmaschine ein geringer Anteil von Farbe zugeführt wird. Der Einsatz einer Emulsion aus Farb- und Feuchtmittel erweist sich insbesondere dann als vorteilhaft, wenn zuvor das Druckwerk mit Farbwerk und Feuchtwerk nach einem Druckauftragswechsel gewaschen wurde. Durch das Waschen des Druckwerks befindet sich dann keine Druckfarbe mehr im Farb- und Feuchtwerk, wobei es sich für den Entwicklungsprozess jedoch als günstig erwiesen hat, wenn ein geringer Anteil von Farbe dem Feuchtmittel beigemengt wird. Wenn das Farb- und Feuchtwerk gewaschen wurde, muss vor dem Druck ein Farbeinlauf durchgeführt werden. Gegen Ende des Farbeinlaufs wird auch das Feuchtwerk eingeschaltet und die Druckplatte durch das Aufsetzen der Feuchtauftragswalze angefeuchtet. Die prozesslose Druckplatte kommt erstmals mit Feuchte in Berührung und die nichtdruckenden Stellen der Druckplatte quellen unter dem Einfluss von Feuchte und Feuchtauftragswalze. Um für den weiteren Entwicklungsprozess eine günstige Emulsion zur Verbesserung des Quellvorgangs zu bekommen, kann das Farbwerk kurzzeitig mit dem Feuchtwerk in Verbindung gebracht werden, so dass eine kleine Farbmenge in das Feuchtwerk gelangt, welche für die Bildung der Emulsion aus Feuchte und Farbe benötigt wird. Ein nachfolgendes weiteres Anfeuchten der Druckplatte mit der überwiegend aus Feuchte bestehenden Farb-/Feuchteemulsion begünstigt das weitere Quellen der Platte. Mit Aufsetzen der Farbauftragswalzen werden die gequollenen nichtdruckenden Bildbereiche von der Druckplatte relativ schnell durch die Farbe entfernt und die Platte läuft frei.

Wenn das Druckwerk nicht gewaschen wird, ist ein kleiner Anteil von Farbe automatisch im Feuchtwerk, so dass sich durch die Zugabe von reinem Feuchtmittel die gleichen Bedingungen ergeben. Durch das Einbringen von einer Emulsion aus Farbe- und Feuchtmittel in die gewaschenen Druckwerke wird somit lediglich der gleiche Zustand hergestellt, wie er sich bei nicht gewaschenem Druckwerk auch einstellen würde. Es ist dabei jedoch sehr wichtig, dass der Farbanteil sehr gering bleibt, so dass der Feuchtmittelanteil auf jeden Fall deutlich überwiegt.

Um bei gewaschenem Druckwerk die Emulsion aus Farbe und Feuchtmittel zu erzeugen, kann während des Entwickelns der Druckplatte vor dem Fortdruckbeginn das Farbwerk kurzzeitig für den Bruchteil einer Umdrehung angestellt werden, so dass die Emulsion aus wenig Farbe und viel Feuchtmittel leicht auf der Druckplatte hergestellt werden kann. Dieses kurze Anstellen des Farbwerks geschieht noch während des Quellprozesses und ist nicht mit dem Farbauftrag zu verwechseln, welcher nach dem Quellprozess zum Entfernen der abzuziehenden Schicht von der Druckplatte erfolgt. Der Prozess des Quellens ist solange durchzuführen, dass später beim Entfernen der Schicht durch den Auftrag von Farbe die Druckplatte nicht zuschmiert. Dies kann nur durch eine ausreichend lange Anfeuchtung mit einer ausreichenden Feuchtmittelmenge sichergestellt werden.

Vorteilhafter Weise ist vorgesehen, dass vor der Aufnahme des Fortdrucks durch Anstellen des Farbwerks an die Druckplatte Farbe zum Abziehen der entwickelten Plattenschicht eingebracht wird. Um die aufgequollene Schicht zu entfernen, wird zeitlich eng benachbart zum Fortdruckbeginn das Farbwerk angestellt, so dass sich auf der ausreichend feuchten Druckplatte eine Farbschicht ergibt. Durch den Kontakt der Farbschicht mit den benachbarten Walzen des Farb- und Feuchtwerks oder des Gummituchzylinders wird dann die oberste aufgequollene Plattenschicht entfernt und der eigentliche Entwicklungsprozess vollendet. Die Farbschicht wird benötigt, um eine entsprechende Zugwirkung auf die aufgequollene Oberfläche durch die benachbarten Walzen und Zylinder herzustellen. Durch den ausreichend langen Vorfeuchtungsprozess kann dann das Abtragen der Schicht nach wenigen Umdrehungen des Plattenzylinders abgeschlossen werden. In der Regel wird dabei die Druckplatte drei Maschinenumdrehungen lang eingefärbt, bevor der Fortdruck beginnt. Zum Fortdruck wird dann der Plattenzylinder an den Gummituchzylinder angestellt, der Papierlauf von Bogen oder Bahn eingeschaltet und der Gummituchzylinder auf das Druckmedium geschaltet.

Vorteilhafter Weise ist außerdem vorgesehen, dass das Anfeuchten zum Entwickeln der Druckplatte bei maximal möglichen oder erhöhtem Feuchtmittelauftrag des Feuchtwerks vorgenommen wird. Um den Quellprozess möglichst kurz und effektiv zu gestalten, sind die Regler für den Feuchtmittelauftrag beim Entwickeln der Druckplatte auf die maximal mögliche Feuchtmittelmenge einzustellen. Dadurch wird sichergestellt, dass ausreichend Feuchtmittel in möglichst kurzer Zeit auf die zu entwickelte Druckplatte aufgetragen wird.

Ein weiterer Vorteil ergibt sich dadurch, dass das Anfeuchten zum Entwickeln der Druckplatte bei einer zeitlich oder maschinenumdrehungsabhängigen veränderlichen Feuchtmittelmenge vorgenommen wird. Damit kann die Feuchtmittelmenge mittels Kennlinien und in Abhängigkeit der Maschinengeschwindigkeit durch den Steuerungsrechner der Druckmaschine optimal an den Entwicklungsprozess angepasst werden.

Ein weiterer Vorteil ergibt sich dadurch, dass der Feuchtmittelauftrag bei relativ langsamen Druckgeschwindigkeiten, insbesondere zwischen 2000 bis 9500 Bogen pro Stunde bei Bogendruckmaschinen, erfolgt. Eine im Vergleich zu Fortdruckgeschwindigkeiten von über 18 000 Bogen pro Stunde deutlich langsamere Betriebsgeschwindigkeit der Druckmaschine hat in Versuchen den Feuchtmittelauftrag weiter verbessert. Die gleiche reduzierte Geschwindigkeit hat sich auch beim kurzen Farbauftrag zum Abziehen der Schicht von der Druckplatte als günstig erwiesen. Das Abziehen der Schicht durch die an den Plattenzylinder angestellten Farbauftragswalzen geschieht bevorzugt ohne eingeschalteten Papierlauf, so dass keine unnötige Makulatur entsteht.

Weiterhin ist vorgesehen, dass nach dem Entwickeln der Druckplatten alle Druckwerke der Druckmaschine mit der gleichen Druckgeschwindigkeit auf Fortdruck umgeschaltet werden. Da in diesem Fall alle Druckwerke bei der gleichen Druckgeschwindigkeit auf Fortdruck umgeschaltet werden, ergeben sich an allen Druckwerken auch die gleichen Zustände beim Abtragen der Schicht nach dem Farbauftrag. Sowie auch der Feuchtmittelauftrag bzw. der Auftrag der Emulsionen aus Feuchtmittel und Farbe möglichst bei geringen Druckgeschwindigkeiten zwischen 2000 bis 9500 Bogen pro Stunde bei Bogendruckmaschinen erfolgt, so sollte auch das Umschalten auf den Fortdruckbetrieb bei einer relativ geringen Druckgeschwindigkeit zwischen 2000 bis 9500 Bogen pro Stunde bei Bogendruckmaschinen erfolgen. Das Abtragen der Schicht beim Umschalten auf den Fortdruckbetrieb gelingt bei dieser relativ geringen Druckgeschwindigkeit besser.

In einer besonders vorteilhaften Ausgestaltung der Erfindung ist vorgesehen, dass die Druckmaschine einen Steuerungsrechner aufweist und dass der Steuerungsrechner auf die Einstellungen von Farbwerk und Feuchtwerk in der Druckmaschine einwirkt, sowie dass der Steuerungsrechner für den Betriebszustand vor dem Fortdruck die Auswahlmöglichkeit eines speziellen Programms zum Anfeuchten und Entwickeln von belichteten Druckplatten aufweist. Dadurch wird sichergestellt, dass das Entwickeln der belichteten Druckplatten in der Maschine nicht mit der bei der normalen Inbetriebnahme erforderlichen Menge von Feuchtmittel und Farbe geschieht, sondern dass dem benötigten Quellprozess für einen korrekten Abtrag der Schicht in den nicht belichteten oder belichteten Bereichen der zu entwickelnden Druckplatte genügend Zeit gegeben wird. Wenn der Drucker eine neue belichtete Druckplatte in der Druckmaschine eingelegt hat, so kann er das Programm "DoP" auswählen, welches automatisch die entsprechenden Schritte zum optimalen Quellen und anschließend Abtrag der Schicht ermöglicht. Dies hat den großen Vorteil, dass dieses Programm reproduzierbar ist und der Drucker nicht selbst aus der unzähligen Anzahl von Einstellungen für Farbe und Feuchtwerk einen halbwegs passenden Feucht-und Farbmittelauftrag zum Entwickeln der Druckplatte einstellen muss. Damit wird ein falsch eingestellter und Fehler behafteter Entwicklungsprozess der Druckplatte mit anstehenden Qualitätsproblemen vermieden und für die meisten Drucker der Einsatz von DoP-Druckplatten erst interessant.

In einer besonders vorteilhaften Ausgestaltung der Erfindung ist vorgesehen, dass in der Druckmaschine ein Sensor zur Unterscheidung zwischen einer entwickelten und einer nicht entwickelten Druckplatte in wenigstens einem Druckwerk vorgesehen ist. Ein solcher Sensor kann die Oberfläche der eingelegten Druckplatte erfassen und feststellen, ob auf der Druckplatte bereits abgetragene Bereiche vorliegen. In diesem Fall würde der Sensor eine bereits entwickelte Druckplatte erkennen, so dass das spezielle Programm zum Entwickeln der Druckplatte nicht eingesetzt werden braucht. Falls der Sensor jedoch keine abgetragene Schicht auf der Druckplatte erkennen kann, ist davon auszugehen, dass es sich um eine neue belichtete aber noch nicht entwickelte Druckplatte handelt, zu deren Entwicklung das spezielle Programm zum Anfeuchten und Entwickeln benutzt werden muss. In Abhängigkeit der Ermittlungsergebnisse des Sensors kann das spezielle Programm zum Entwickeln der Druckplatte automatisch in der Druckmaschine ausgeführt werden. Alternativ kann auch vorgesehen sein, dass dem Drucker an einem Bildschirm zunächst der Hinweis optisch oder in einer anderen Ausführungsform auch akustisch übermittelt wird, dass eine neue noch nicht entwickelte Druckplatte eingelegt ist und dem Drucker die Auswahl des speziellen Programms zum Entwickeln angeboten wird. Durch eine Quittierungseingabe kann dann der Drucker das spezielle DoP-Programm dann starten. Selbstverständlich ist auch eine rein manuelle Auswahl von Druckwerken durch das Bedienpersonal denkbar, wobei bei den manuell ausgewählten Druckwerken dann das spezielle DoP-Programm durchgeführt wird. Diese Lösung ist jedoch gegen falsche Eingaben des Druckers nicht abgesichert.

Es ist des Weiteren vorgesehen, dass das spezielle Programm zum Entwickeln der belichteten Druckplatte mit dem Fortdruckbeginn automatisch abgeschaltet wird. Da das spezielle Programm nur bei neuen noch nicht entwickelten Druckplatten sinnvoll ist, kann durch die automatische Abschaltung nach Fortdruckbeginn sichergestellt werden, das bei erneutem Druckbeginn mit der gleichen oder einer anderen bereist entwickelten Druckplatte nicht aus Versehen das spezielle Programm zum Entwickeln unnötigerweise gestartet wird. Auch wenn der Drucker dann vergisst, dass er bei einer bereits entwickelten Druckplatte das spezielle Programm nicht braucht, so wird durch diese Ausführungsform automatisch dafür gesorgt, dass das spezielle Programm bei einer entwickelten Druckplatte auch nicht aus Versehen zum Einsatz kommt.

Vorteilhafter Weise ist weiterhin vorgesehen, dass die Druckmaschine mehrere Druckwerke zur Aufnahme von außerhalb und innerhalb der Druckmaschine entwickelten Druckplatten aufweist und dass mittels der Sensoren in den Druckwerken nur jeweils für Druckwerke mit eingelegten, zu entwickelten Druckplatten das spezielle DoP-Programm zur Entwicklung der Druckplatte in der Druckmaschine vom Steuerungsrechner ausgewählt wird. In einer solchen Druckmaschine können mit hoher Betriebssicherheit sowohl außerhalb als auch innerhalb der Druckmaschine zu entwickelnde Druckplatten verwendet werden. Da der Sensor zwischen entwickelten und nicht entwickelten Druckplatten unterscheiden kann, muss sich der Drucker um die richtige Behandlung der Druckplatten keine Gedanken machen. In Abhängigkeit der durch die Sensoren erkannten Platte wird nur in dem jeweils betroffenen Druckwerk automatisch oder nach Hinweis an den Drucker bei den noch nicht entwickelten Druckplatten das spezielle DoP-Programm zum Entwickeln von Druckplatten gestartet. In den Druckwerken mit außerhalb der Druckmaschine entwickelten Druckplatten wird das spezielle Programm jedoch nicht benötigt und auch nicht verwendet. Damit werden Bedienfehler durch den Drucker auf ein Minimum reduziert und so auch der zuverlässige Betrieb von verschiedenen Druckplatten in einer Druckmaschine gewährleistet.

Der Sensor oder eine zusätzliche Kamera können auch dazu genutzt werden, den Entschichtungsprozess beim Entwickeln der Druckplatte zu überwachen. Falls eine unzureichende Entschichtung festgestellt wird, kann der Steuerungsrechner zukünftig mehr Feuchtmittel hinzugeben oder das Abziehen der Schicht verlängern, bis die Druckplatte sauber ist und so in den Entwicklungsprozess optimierend eingreifen.

Die vorliegende Erfindung wird nachfolgend anhand von mehrerer Figuren näher beschrieben und erläutert. Es zeigen:
- Fig. 1:: eine Mehrfarben-Bogenoffsetdruckmaschine mit einem Steuerungsrechner und einem angeschlossenen Druckplattenbelichter,
- Fig. 2:: die Auswahlmöglichkeit eines speziellen DoP-Programms zum Entwickeln von Druckplatten in der Druckmaschine,
- Fig. 3:: die Vorgänge beim Entwickeln einer Druckplatte in der Druckmaschine,
- Fig. 4:: eine erste Variante eines speziellen DoP-Programms zum Entwickeln von Druckplatten in der Druckmaschine mit verlängertem Vorfeuchten,
- Fig. 5:: eine zweite Variante eines speziellen DoP-Programms zum Entwickeln von Druckplatten in der Druckmaschine mit separatem Anfeuchten und verlängertem Vorfeuchten und
- Fig. 6:: eine dritte Variante eines speziellen DoP-Programms zum Entwickeln von Druckplatten in der Druckmaschine mit separatem Plattenanfeuchten und Entschichten.

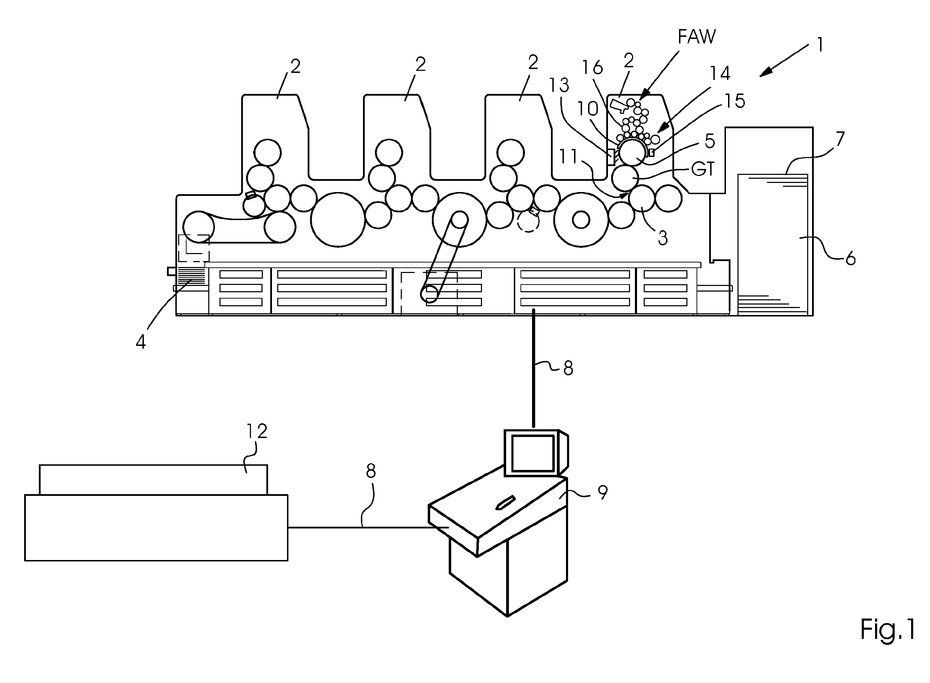

In Figur 1 ist eine Bogenoffsetdruckmaschine 1 mit vier Druckwerken 2 abgebildet. Jedes der vier Druckwerke 2 verfügt über ein Farbwerk FAW und ein Feuchtwerk 14. Aus dem Farbwerk FAW werden über Farbwerkswalzen 16 die Plattenzylinder 5 in den Druckwerken 2 im Druckbetrieb mit Druckfarbe beaufschlagt. Um die Konsistenz der Druckfarbe im Farbwerk FAW beeinflussen zu können, weist jedes der Druckwerke 2 außerdem ein Feuchtwerk 14 auf. Das Feuchtwerk 14 gibt an das Farbwerk FAW Feuchtmittel ab, um so die Konsistenz der Farbe verändern zu können. Farbwerk FAW und Feuchtwerk 14 sind separat an den Plattenzylinder 5 anstellbar und Feuchtwerk 14 und Farbwerk FAW können auch voneinander abgestellt werden. Der Plattenzylinder 5 trägt eine Druckplatte 10, welche den Farbauszug für das jeweilige Druckwerk 2 enthält. Die Farbauszüge auf den Druckplatten 10 der Druckwerke 2 werden in der Druckvorstufe durch Zerlegung der Druckvorlage in die einzelnen Druckfarben hergestellt. Zur Belichtung der Druckplatte 10 mit dem jeweiligen Farbauszug ist in der Druckvorstufe ein Druckplattenbelichter 12 vorhanden. In diesem Druckplattenbelichter 12 werden die druckenden Bereiche der Druckplatte 10 mittels eines Lasers beschrieben, so dass sich die Beschaffenheit der Oberfläche in den druckenden Bereichen verändert. Nach dem Beschreiben im Druckplattenbelichter 12 können die Druckplatten 10 auf die Plattenzylinder 5 in der Druckmaschine gespannt werden. Bei prozesslosen Druckplatten nach dem DoP-Prinzip findet die Entwicklung d. h. das Abtragen der Oberschicht der Druckplatte 10 in den nichtdruckenden Bereichen in der Druckmaschine 1 statt.

Um die Schicht in den nichtdruckenden Bereichen auf der Druckplatte 10 abzutragen, wird die Druckplatte 10 mit Feuchtmittel aus dem Feuchtwerk 14 angefeuchtet. Dies geschieht für eine wenigstens eineinhalbfach so lange Zeitspanne oder Anzahl von Umdrehungen in der Druckmaschine 1, als dies bei bereits fertig entwickelten Druckplatten 10 der Fall ist. Durch dieses deutlich verlängerte Anfeuchten, welches durchaus auch vier bis fünf Mal so lang wie bei einer entwickelten Platte 10 durchgeführt werden kann, quillt die Oberfläche der Druckplatte 10 in den nicht belichteten Bereichen auf. Die so aufgequollene Oberfläche kann dann durch einen Farbauftrag aus dem Farbwerks FAW von der Druckplatte 10 entfernt werden. Durch das Anhaften der Farbe an der obersten Schicht der prozesslosen Druckplatte 10 und wiederum das Anhaften der Farbe an dem Gummituchzylinder GT wird die angequollene Oberschicht der Druckplatte 10 heruntergerissen und so nach wenigen Umdrehungen der Druckmaschine 1 entfernt. In der Regel reichen drei Maschinenumdrehungen aus, bevor der Fortdruckbetrieb beginnt. Im Fortdruckbetrieb wird die Druckplatte 10 auf dem Plattenzylinder 5 mit ausreichend Druckfarbe aus dem Farbwerk FAW versorgt, welche bei angestellten Gummituchzylinder GT auf die Oberfläche des Gummituchzylinders GT übertragen wird. Der Gummituchzylinder GT ist wiederum im Druckbetrieb an den Gegendruckzylinder 3 angestellt, so dass die Farbe vom Gummituchzylinder GT im Druckspalt 11 zwischen Gegendruckzylinder 3 und Gummituchzylinder GT auf den Bedruckstoff 7 übertragen werden kann.

Die Bedruckstoffe 7 werden in der Bogendruckmaschine 1 einem Anleger 6 entnommen und über Zylinder durch die einzelnen Druckwerke 2 transportiert. Nach dem letzten Druckwerk 2 weist die Bogendruckmaschine 1 einen Ausleger 4 auf, in dem die fertig bedruckten Bogen 7 abgelegt werden. Der Antriebsmotor für die Bogendruckmaschine 1, sowie wie die Stellmotoren im Feuchtwerk 14 und Farbwerk FAW können über ein Bedienpult 9 mit einem Steuerungsrechner betätigt werden. Der Steuerungsrechner im Bedienpult 9 ist so ausgestaltet, dass er die nötigen Regelvorgänge insbesondere am Feuchtwerk 14 und Farbwerk FAW weitgehend automatisch vornehmen kann. Über einen Bildschirm am Bedienpult 9 kann das Bedienpersonal Einstellungen an der Druckmaschine 1 vornehmen und den Betriebszustand ablesen. Dazu ist das Bedienpult 9 über eine Kommunikationsverbindung 8 mit den elektronischen Steuerungseinrichtungen der Druckmaschine 1 verbunden. Weiterhin ist das Bedienpult 9 über eine Kommunikationsverbindung 8 mit dem Druckplattenbelichter 12 in der Druckvorstufe verbunden. Auf diese Art und Weise kann die Druckmaschine1 mittels Bedienpult 9 auch Daten mit der Druckvorstufe austauschen. Der Steuerungsrechner im Bedienpult 9 beinhaltet außerdem ein spezielles Steuerungsprogramm zum Entfernen der nicht belichteten Schicht auf prozesslosen Druckplatten 10. Dieses spezielle DoP-Programm löst der Drucker entweder manuell am Bedienpult 9 aus, wenn er eine belichtete aber noch nicht entwickelte Druckplatte 10 in eines der Druckwerke 2 eingelegt hat, oder in jedem der Druckwerke 2 ist ein Sensor 15 vorhanden, welcher die eingelegten Druckplatten 10 optisch abtastet und aufgrund der veränderten Oberflächenbeschaffenheit eine belichtete aber noch nicht entwickelte Druckplatte 10 erkennt. Meldet der Sensor 15 eine solche Druckplatte 10 an das Bedienpult 9, so erhält der Bediener auf dem Bildschirm am Bedienpult 9 einen Hinweis, dass er für dieses Druckwerk 2 das spezielle DoP-Programm zum Entfernen der Schicht in den nicht belichteten Bereichen starten soll. Der Rechner im Bedienpult 9 kann auch so ausgestaltet sein, dass das spezielle DoP-Programm zum Entfernen der Schicht in den nicht belichteten Bereichen beim Erkennen einer noch nicht entwickelten Druckplatte 10 durch den Sensor 15 im betroffenen Druckwerk 2 automatisch durchgeführt wird. Weiterhin ist in Fig. 1 im Druckwerk 2 eine Kamera 13 vorhanden, welche an das Bedienpult 9 mit dem Steuerungsrechner angeschlossen ist. Diese Kamera 13 überwacht das Entfernen der entwickelten Schicht von der Druckplatte 10, so dass der Steuerungsrechner im Bedienpult 9 anhand der Daten der Kamera 13 die verschiedenen Parameter beim Anfeuchten, Entwickeln und Abziehen der Schicht von der Druckplatte 10 mittels Druckfarbe optimieren kann.

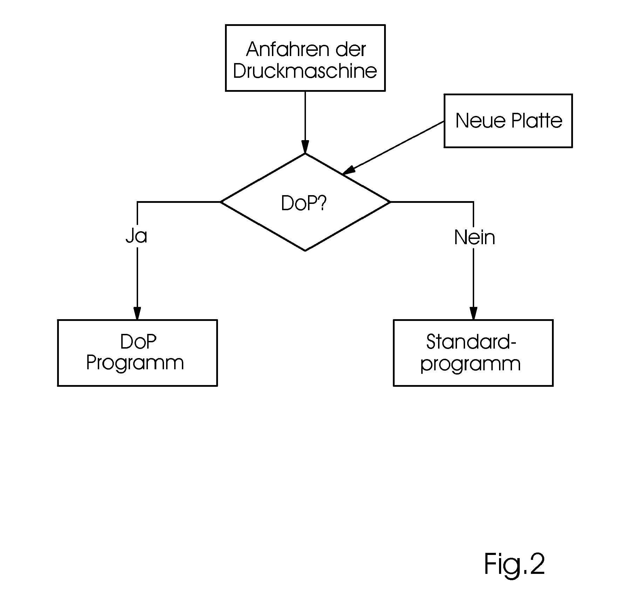

Figur 2 zeigt den Vorgang bei der Auswahl des speziellen DoP-Programms zum Entfernen der Schicht und zur Entwicklung der Platte 10. Entweder der Drucker teilt dem Steuerungsrechner im Bedienpult 9 manuell mit, dass er eine neue nicht entwickelte Druckplatte 10 in eins der Druckwerke 2 eingelegt hat oder das Einlegen einer solchen Platte wird durch den Sensor 15 im Druckwerk 2 automatisch erkannt. Falls eine solche Druckplatte 10 erkannt wird, wird das spezielle DoP-Programm zum Entfernen der Schicht verwendet, welches in den weiteren Figuren in mehreren Varianten näher beschrieben wird. Falls jedoch nur bereits entwickelte Druckplatten 10 in den Druckwerken 2 der Druckmaschine 1 vorhanden sind, so läuft das ganz normale Standartprogramm an, mit dem die Bogendruckmaschine 1 in Betrieb genommen wird.

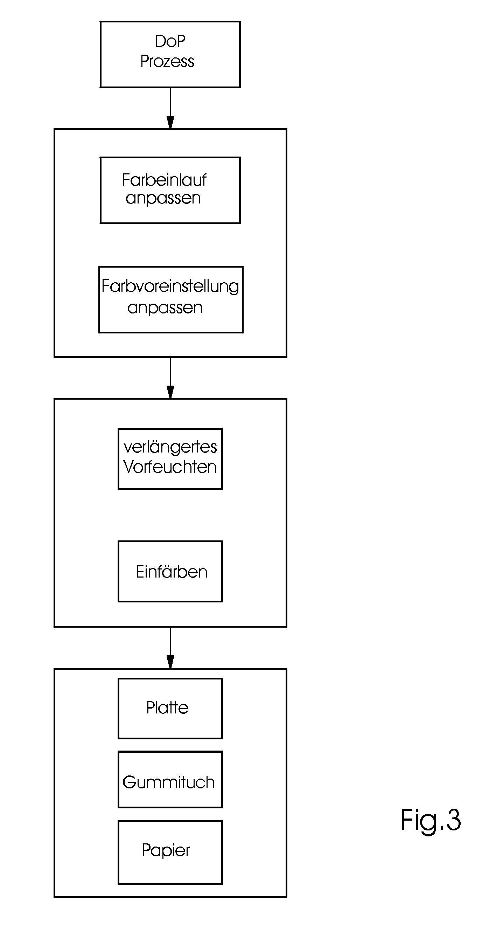

Gemäß Figur 3 besteht das spezielle DoP-Programm zum Entfernen der Schicht aus mehreren Prozessen. Im Unterschied zur normalen Inbetriebnahme der Druckmaschine 1 mit entwickelten Druckplatten 10 werden bei nicht entwickelten prozesslosen Druckplatten 10 ein angepasster Farbeinlauf und eine angepasste Farbvoreinstellung vorgenommen. Als Kernstück beinhaltet das DoP-Programm einen speziellen länger andauernden Vorfeuchtungsprozess, mit dem das Quellen der Oberfläche der Druckplatte 10 ausreichend sichergestellt wird. Zum Abtragen der angequollenen Schicht in den nicht belichteten Bereichen auf der Druckplatte 10 wird die Oberfläche der Druckplatte 10 kurz eingefärbt, so dass die eingefärbten angequollenen Bereiche in Verbindung mit den Farbauftragswalzen 16 des Farbwerks FAW in Berührung kommen und die Schicht von der Druckplatte 10 abgezogen werden kann und die Druckplatte so entwickelt wird. Nach der Entwicklung der Platte 10 auf dem Plattenzylinder 5 in den Druckwerken 2 wird der Plattenzylinder 5 mit dem Gummituchzylinder GT in Kontakt gebracht und der Gummituchzylinder GT an den Gegendruckzylinder 3 angestellt. Zuvor wird noch der Papierlauf eingeschaltet, so dass die ersten Druckbogen 7 den Druckspalt 11 in den Druckwerken 2 erreichen, bevor Gegendruckzylinder 3 und Gummituchzylinder GT aneinander angestellt sind. Damit ist der Fortdruckbetrieb erreicht und die Produktion der Bedruckstoffe 7 kann beginnen.

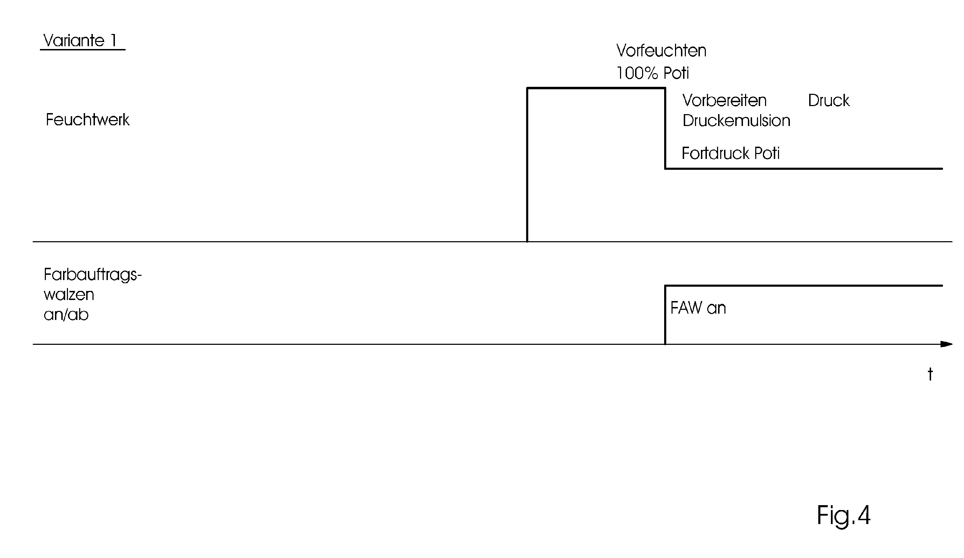

Eine erste Variante eines Programms zum Entfernen der nicht belichteten Oberschicht der Druckplatte 10 ist Fig. 4 zu entnehmen. Wie auch bei den nachfolgenden Varianten erstreckt sich die Zeitachse t von links nach rechts in der Entwicklungsphase der Druckplatte 10 und dem Fortdruckbeginn. Von oben nach unten sind Feuchtwerk 14 und die Farbwalzen 16 des Farbwerks FAW in einem Druckwerk 2 aufgeführt, welche beim Entwickeln der Druckplatte 10 zeitweise an- und abgeschaltet werden. Einstellungen der Feuchtmittelmenge im Feuchtwerk 14 werden mittels eines Potentiometers Poti am Bedienpult 9 der Druckmaschine 1 vorgenommen. Bei der ersten Variante 1 in Fig. 4 wird zunächst mit maximalem Feuchtmittelauftrag für eine längere Zeitdauer oder Anzahl von Maschinenumdrehungen angefeuchtet, was auch als Vorfeuchten bezeichnet wird, um die nichtdruckende Schicht der Platte 10 zum Quellen zu bringen. Dazu beträgt die Einstellung des Potentiometers Poti am Feuchtwerk 14 100 %. Direkt im Anschluss daran wird die Einstellung des Potentiometers Poti verringert und mit dem Aufsetzen der Farbauftragswalzen 16 die gequollene Plattenschicht abgezogen. Dann wird für den Fortdruckbetrieb die Druckemulsion aus Feuchtmittel und Farbe eingestellt. Nach einigen Umdrehungen der Platte 10 auf dem Plattenzylinder 5 beginnt dann der Fortdruck.

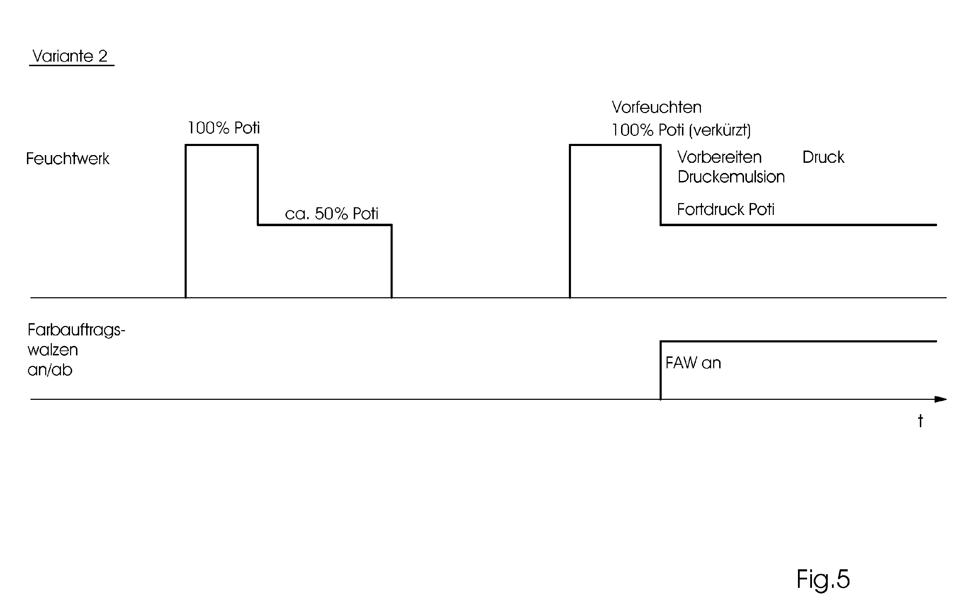

Bei der zweiten Variante in Fig. 5 wird zunächst mit maximalem Feuchtmittelauftrag vorgefeuchtet. Dazu beträgt die Einstellung des Potentiometers am Feuchtwerk 14 100 %. Nach relativ kurzer Zeit wird der Feuchtmittelauftrag auf etwa 50 % bzw. Fortdruckeinstellung des Potentiometers Poti verringert. Anschließend startet das normale Programm zur Vorbereitung des Fortdruckbetriebs, bei dem zunächst mit verlängerter Vorfeuchtdauer und maximaler Feuchte die entwickelte Druckplatte 10 vorgefeuchtet wird und dann mit verringerter Einstellung am Potentiometer Poti und durch Aufsetzen der Farbauftragswalzen 16 auf die Druckplatte 10 die gequollene Plattenschicht abgezogen wird. Danach wird die Druckemulsion aus Feuchtmittel und Farbe eingestellt. Nach einigen Umdrehungen der Platte 10 auf dem Plattenzylinder 5 beginnt der Fortdruck.

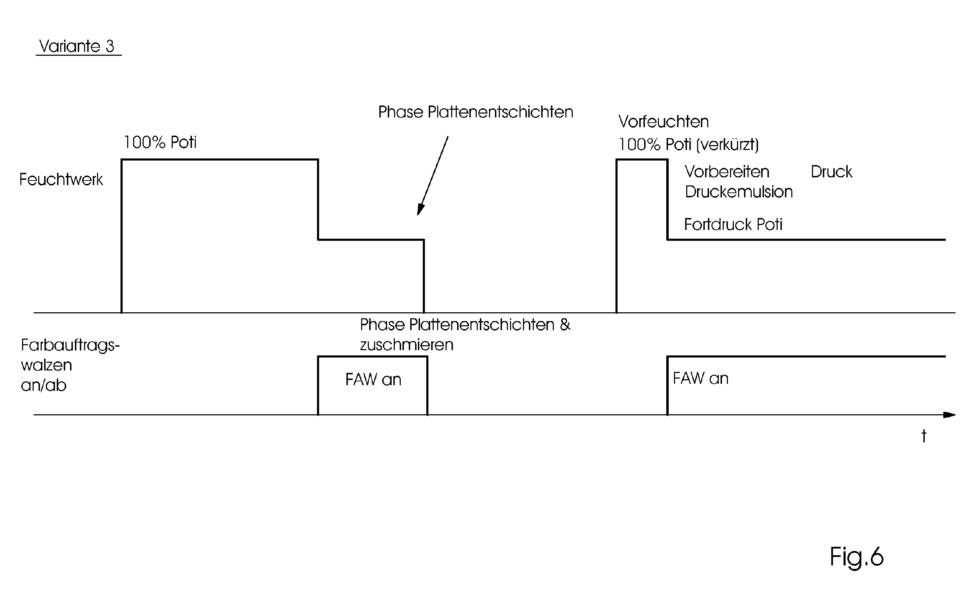

Bei der dritten Variante 3 gemäß Fig. 6 wird zunächst mit maximalem Feuchtmittelauftrag für eine längere Zeitdauer oder Anzahl von Maschinenumdrehungen vorgefeuchtet, um die nichtdruckende Schicht der Platte 10 zum Quellen zu bringen. Dazu beträgt die Einstellung des Potentiometers am Feuchtwerk 14 100 %. Direkt im Anschluss daran wird die Einstellung des Potentiometers Poti verringert und mit dem Aufsetzen der Farbauftragswalzen 16 die gequollene Plattenschicht abgezogen. Im Gegensatz zur ersten Variante in Fig. 4 beginnt dann nicht der Fortdruck, sondern der Prozess wird nach einigen Umdrehungen der Platte 10 auf dem Plattenzylinder 5 beendet. Die Platte 10 ist dann fertig entwickelt und kann in der Maschine 1 verbleiben, bis der Drucker den Fortdruck aktivieren möchte. Mit Aktivierung des Fortdrucks läuft dann das normale Anfahrprogramm aus Vorfeuchten und anschließendem Aufsetzen der Farbauftragswalzen 16 zum Einstellen der Druckemulsion aus Farbe und Feuchtmittel ab, bevor der eigentliche Druck beginnt.

Den Varianten 1 bis 3 ist gemeinsam, dass die Summe des Plattenanfeuchtens und Vorfeuchtens wenigstens eineinhalbfach so lang dauert wie bei der Druckvorbereitung bei bereits entwickelten Druckplatten 10. Damit wird sichergestellt, dass die Oberfläche einer noch nicht entwickelten Druckplatte 10 genügend anquellen kann, so dass die Nichtbildbereiche der Druckplatte 10 mit dem Aufsetzen der Farbauftragswalzen 16 zügig und sauber innerhalb weniger Umdrehungen der Druckmaschine 1 entfernt werden können.

### Bezugszeichenliste

- 1: Bogendruckmaschine
- 2: Druckwerk
- 3: Gegendruckzylinder
- 4: Ausleger
- 5: Plattenzylinder
- 6: Anleger
- 7: Druckbogen
- 8: Kommunikationsverbindung
- 9: Bedienpult
- 10: Druckplatte
- 11: Druckspalt
- 12: Druckplattenbelichter
- 13: Kamera
- 14: Feuchtwerk
- 15: Sensor
- 16: Farbwalzen
- FAW: Farbwerk
- GT: Gummituchzylinder
- Poti: Einstellung Potentiometer

## Patentansprüche

1. Verfahren zur Entwicklung von Druckplatten (10) in einer Druckmaschine (1) mit wenigstens einem Druckwerk (2),
**dadurch gekennzeichnet,**
**dass** eine bebilderte, nicht entwickelte Druckplatte (10) in wenigstens einem Druckwerk (2) der Druckmaschine (1) vor dem Druckbeginn zum Anfeuchten mit Feuchtmittel für eine Einwirkungsdauer beaufschlagt wird, welche wenigstens der eineinhalbfachen Zeitspanne oder Anzahl von Maschinenumdrehungen entspricht, welche beim Einsatz einer bereits entwickelten Druckplatte (10) in der selben Druckmaschine (1) vor dem Druckbeginn vorgesehen sind.

2. Verfahren nach Anspruch 1,
**dadurch gekennzeichnet,**
**dass** die Einwirkdauer des Feuchtmittels zum Anfeuchten der Druckplatte (10) aufgeteilt wird auf eine oder mehrere separate Anfeuchtphasen und das Anfeuchten vor Fortdruckbeginn.

3. Verfahren nach einem der vorhergehenden Ansprüche,
**dadurch gekennzeichnet,**
**dass** für eine Emulsion aus Farbe und Feuchtmittel dem Feuchtmittel beim Entwickeln der Druckplatte (10) in der Druckmaschine (1) ein geringer Anteil von Farbe zugeführt wird.

4. Verfahren nach einem der vorhergehenden Ansprüche,
**dadurch gekennzeichnet,**
**dass** vor der Aufnahme des Fortdrucks, auf die Druckplatte (10) Farbe zum Abziehen der entwickelten Plattenschicht durch Anstellen des Farbwerks (FAW) aufgebracht wird.

5. Verfahren nach einem der vorhergehenden Ansprüche,
**dadurch gekennzeichnet,**
**dass** vor oder während dem Anstellen des Farbwerks (FAW) die Druckplatte (10) mit maximal möglichem oder erhöhtem Feuchtmittelauftrag durch das Feuchtwerk (14) versorgt wird.

6. Verfahren nach einem der vorhergehenden Ansprüche,
**dadurch gekennzeichnet,**
**dass** nach einem Waschen des Farbwerks (FAW) und des Feuchtwerks (14) und nach dem Farbeinlaufund dem erstmaligen Anfeuchten der zu entwickelten Druckplatte (10) das Farbwerk (FAW) kurzzeitig in Kontakt mit dem Feuchtwerk (14) geschaltet wird.

7. Verfahren nach einem der vorhergehenden Ansprüche,
**dadurch gekennzeichnet,**
**dass** das Anfeuchten der Platte (10) bei an die Druckplatte (10) angestelltem Feuchtwerk (14) und von der Druckplatte (10) abgestelltem Farbwerk (FAW) vorgenommen wird.

8. Verfahren nach einem der vorhergehenden Ansprüche,
**dadurch gekennzeichnet,**
**dass** beim Anfeuchten der Platte (10) das Feuchtwerk (14) und Farbwerk (FAW) voneinander getrennt sind.

9. Verfahren nach einem der vorhergehenden Ansprüche,
**dadurch gekennzeichnet,**
**dass** das Anfeuchten zum Entwickeln der Druckplatte (10) bei maximal möglichem oder erhöhtem Feuchtmittelauftrag des Feuchtwerks (14) vorgenommen wird.

10. Verfahren nach einem der vorhergehenden Ansprüche,
**dadurch gekennzeichnet,**
**dass** das Anfeuchten zum Entwickeln der Druckplatte (10) bei einer zeitlich oder maschinenumdrehungsabhängigen veränderlichen Feuchtmittelmenge vorgenommen wird.

11. Verfahren nach einem der vorhergehenden Ansprüche,
**dadurch gekennzeichnet,**
**dass** das Anfeuchten der Platte (10) während einer separaten Anfeuchtphase vorgenommen wird.

12. Verfahren nach einem der vorhergehenden Ansprüche,
**dadurch gekennzeichnet,**
**dass** das Anfeuchten zum Entwickeln der Druckplatte (10) bei einer separaten Anfeuchtphase erfolgt, wobei ein hoher oder maximaler Feuchtmittelauftrag des Feuchtwerks (14) zu Beginn der Anfeuchtphase und anschließend ein niedrigerer Feuchtmittelauftrag im weiteren Verlauf der Anfeuchtphase vorgenommen wird.

13. Verfahren nach einem der Ansprüche 3 bis 12,
**dadurch gekennzeichnet,**
**dass** der Feuchtmittelauftrag oder der Auftrag der Farb-/Feuchtmittelemulsion bei relativ langsamen Druckgeschwindigkeiten, insbesondere zwischen 2000 bis 9500 Bogen pro Stunde bei Bogendruckmaschinen, erfolgt.

14. Verfahren nach einem der vorhergehenden Ansprüche,
**dadurch gekennzeichnet,**
**dass** alle Druckwerke (2) mit einer relativ geringen Druckgeschwindigkeit, insbesondere zwischen 2000 bis 9500 Bogen pro Stunde bei Bogendruckmaschinen, auf Fortdruck umgeschaltet werden.

15. Verfahren nach einem der vorhergehenden Ansprüche,
**dadurch gekennzeichnet,**
**dass** das Anfeuchten der Druckplatte (10) und das Aufsetzen der Farbauftragswalzen (16) zum Abziehen der entwickelten Plattenschicht von der Druckplatte (10) in einer separaten Phase erfolgt, ohne dass Bogen (7) gedruckt werden.
